Europäisches Patentamt

European Patent Office

Office européen des brevets

(19)

(11) Veröffentlichungsnummer: **0 224 747 B1**

(12)                    # EUROPÄISCHE PATENTSCHRIFT

(45) Veröffentlichungstag der Patentschrift: 02.05.91

(51) Int. Cl.⁵: **H05K 13/04**

(21) Anmeldenummer: 86115400.3

(22) Anmeldetag: 06.11.86

⌡

(54) **Verfahren und Vorrichtung zur Bestückung von Substraten mit Mikropacks.**

(30) Priorität: 12.11.85 DE 3540073

(43) Veröffentlichungstag der Anmeldung:
10.06.87 Patentblatt 87/24

(45) Bekanntmachung des Hinweises auf die
Patenterteilung:
02.05.91 Patentblatt 91/18

(84) Benannte Vertragsstaaten:
**CH DE FR GB LI**

(56) Entgegenhaltungen:
**EP-A- 0 082 559**
**CH-A- 624 525**
**DE-A- 3 424 323**
**US-A- 4 079 489**
**US-A- 4 166 562**

(73) Patentinhaber: **Siemens Aktiengesellschaft**
**Wittelsbacherplatz 2**
**W-8000 München 2(DE)**

(72) Erfinder: **Seidel, Werner**
**Colmarer Strasse 15**
**W-8000 München 70(DE)**
Erfinder: **Kandler, Walter**
**Birkenweg 20**
**W-8130 Starnberg(DE)**

## Beschreibung

Die Erfindung betrifft ein Verfahren und eine Vorrichtung zur Bestückung von Substraten mit Mikropacks.

Der Wunsch nach der Verkleinerung von Leiterplatten führte dazu, daß die Oberflächenmontage von Bauelementen, wie sie schon bei Schichtschaltungen seit langem üblich ist, nun auch zunehmend bei Leiterplatten zur Anwendung kommt.

Dabei werden die oberflächen-lötbaren Bauelemente, die entsprechend dem englischsprachigen Begriff "Surface Mounted Devices" auch kurz SMDs genannt werden, nicht mehr in die Löcher der Platinen gesteckt, sondern auf deren Oberfläche aufgelötet. Sie benötigen 30% bis 60% weniger Platz. Da sich natürlich auch die Zahl der Durchkontaktierungen verringert, kann ingesamt mit einer Kostenreduzierung im Bereich von etwa 50% gerechnet werden.

Durch die Ausweitung der Oberflächenmontage auf Leiterplatten ergab sich die Notwendigkeit, Bauelemente mit veränderten Abmessungen und Anschlüssen zu entwickeln. Als kleinste, flachste und leichteste IC-Bauform entstand als Ergebnis dieser Entwicklung das songenannte Mikropack, bei welchem es sich um eine in Bandform vorliegende integerierte Schaltung handelt.

Mikropacks bestehen beispielsweise aus hermetisch versiegelten Chips mit löftfähigen Kontakten und nach Art von Filmbändern ausgestalteten Bändern mit verzinnten Kupferleitbahnen. Auf der Oberfläche der Chips wird über der Al-Verdrahtung ganzflächig eine dünne Glasschicht abgeschieden und Kontaktlöcher zu den Anschlüssen des ICs freigeäzt. Diese werden wiederum mit lötfähigen, überlappenden Metallschichten in Form von Höckern verschlossen. Das Glas ergibt nun zusammen mit den Höckern einen hermetisch dichten Verschluß des Chips, der so vor Umwelteinflüssen völlig geschützt ist.

Für die Herstellung des Filmbandes dient als Ausgangsmaterial ein 40mm breites, 127μm dikkes, hochtemperaturfestes Polyimid-Band, beschichtet mit einem dünnen Epoxidharzkleber, in das ein Fenster für den Chip und Perforationslöcher entsprechend den Maßen eines Super-8-Filmes gestanzt werden.

Das Polyimid-Band wird dann mit einer Kupferfolie verklebt, mit Fotolack beschichtet und mit einer zum IC passenden Maske belichtet, partiell galvanisch verzinnt und so geäzt, daß feine Cu-Anschlüsse für die Lötung der Chips und die später benötigten Außenanschlüsse der Mikropack-Bauform entstehen.

Durch die flexible Aufhängung des ICs im Mikropack und die ebenfalls flexiblen äußeren Anschlüsse können durch die unterschiedlichen Ausdehnungskoeffizienten der verschiedenen Materialien nur sehr geringe mechanische Kräfte auf den Chip ausgeübt werden. Das bedeutet, die Oberflächenmontage von Mikropacks kann problemlos auf ein- oder mehrlagigen Substraten aus Keramik, Glas, Epoxidharz, Hartpapier oder Polyimid-Folien durchgeführt werden.

Als Verbindungstechnologie für Mikropacks hat sich bislang besonders die impulsgesteuerte Kontaktlötung bewährt. Aber auch das Reflow-, Kondensations- oder Laser-Löten und das Kleben mit elektrisch leitenden Klebern sind mögliche Verbindungsverfahren, wobei die Temperatur, gemessen am Chip, je nach Ausführungsform 220° C bzw. 260° C nicht überschreiten sollte.

Da Mikropacks in Bandform geliefert werden, werden die Außenanschlüsse vor der Bestückung zuerst ausgeformt, worauf die Mikropacks aus den Band ausgeschnitten werden. Die entsprechenden Ausform- und Ausschneidestationen können in den Lötvorrichtungen integriert werden.

Für die Verarbeitung von Mikropacks sind im Handel sogenannte Außenlötmaschinen (Outerlead-Bonder) erhältlich, die alle nach dem gleichen Prinzip arbeiten. Dabei wird ein Metallbügel durch einen kurzen Stromimpuls erhitzt und so das Lot auf der Substratplatte und den Mikropack-Außenanschlüssen zum Schmelzen gebracht. Erst nach dem Erstarren der Lotschicht hebt der Impulslötstempel ab. Eine Gefahr von sogenannten kalten Lötstellen wird somit vermieden. Die genaue Positionierung der Mikropacks auf den Substraten wird unter dem Mikroskop mit entsprechenden Manipulatoren vorgenommen.

Weitere Einzelheiten über Mikropacks gehen aus der Firmendruckschrift "Mikropack eine kompakte IC-Bauform für die Oberflächenmontage" Bestell-Nr.: BI-B 3166, PA 05 855, S3d 3/85, herausgegeben von Siemens AG, Bereich Bauelemente, Produktinformation, Balanstraße 73, D-8000 München 80 hervor.

Für die automatische Bestückung von Leiterplatten oder Keramiksubstraten mit oberflächen-lötbaren Bauelementen wie Widerständen, Kondensatoren, Dioden, Transistoren und dergleichen werden Bestückautomaten eingesetzt, die nach dem sogenannten Pick & Place Prinzip arbeiten. Die Zuführung der Bauelemente richtet sich dabei nach ihrem Anlieferungszustand. Sowohl für Schüttgut, wie auch für Magazine, Vorratsbänder etc. stehen Zuführmodule zur Verfügung, wobei insbesondere Vibrationsrundförderer-Module für Schüttgut, Vibrationslängsförderer-Module für Stangenmagazine und Gurt-Zuführmodule eingesetzt werden. Über diesen Zuführmodulen und der im Bestückbereich ortsfest zentrierten Leiterplatte oder einem im Bestückbereich ortsfest zentrierten Keramiksubstrat bewegt sich ein Bestückkopf, der an eine freiprogrammierbare Positioniereinheit mit zwei Freiheitsgraden angeflanscht ist. Der zur Aufnahme der Bauelemente mit einer Saugpipette und zum Zentrieren der aufgenommenen Bauelemente mit zwei Zangenpaaren ausgerüstete Bestückkopf enthält weitere drei freiprogrammierbare Achsen für die Funktionen Heben und Senken der Saugpipette, Zentrieren der Bauelemente und Drehen der Bauelemente. Der Bestückkopf nimmt die Bauelemente aus den Spuren der Zuführmodule an den jeweiligen Entnahmestellen mit Hilfe der Saugpipette auf, worauf das jeweils aufgenommene Bauelement mit Hilfe der beiden Zangenpaare in zwei Achsrichtungen zentriert, in die Einbaulage gedreht und in der vorgesehenen Bestückposition auf der Leiterplatte oder dem Keramiksubstrat abgesetzt wird. Anschließend werden die derart bestückten Substrate zum Reflow-Löten weitergegeben, wobei die Oberflächenmontage der Bauelemente insbesondere durch die Dampfphasenlötung (Vapor phase soldering) abgeschlossen wird.

In der US-PS 4 135 630 ist ein Bestückautomat beschrieben, der nach dem Pick & Place Prinzip arbeitet und einen mit Saugpipette und zwei Zangenpaaren zum Zentrieren der aufgenommenen Bauelemente ausgerüsteten Bestückkopf besitzt.

Für die Oberflächenmontage von Mikropacks durch Reflow-Lötverfahren wie z. B. der Dampfphasenlötung sollte die Bestückung der Mikropacks zusammen mit den anderen Bauelementen mit dem vorstehend geschilderten Bestückautomaten vergenommen werden können. Die Bestückung von Substraten mit Mikropacks nach dem Pick & Place Prinzip ist jedoch nicht ohne weiteres möglich, da die Mikropack-Bauform für eine Zentrierung der mit der Saugpipette aufgenommenen Bauelemente mit Hilfe von zwei Zangenpaaren viel zu empfindlich ist. Ohne Kenntnis der Relativlage zwischen Mikropack und Bestückkopf ist jedoch ein lagerichtiges Absetzen der Mikropacks in den programmierten Bestückpositionen nicht möglich.

Der Erfindung liegt die Aufgabe zugrunde, ein Verfahren und eine Vorrichtung zur automatischen Bestückung von Substraten mit Mikropacks nach dem Pick & Place Prinzip zu schaffen.

Diese Aufgabe wird bei einem Verfahren zur Bestückung von Mikropacks dadurch gelöst, daß die Mikropacks in Bandform von einer Vorratsrolle abgezogen und in einer Ausschneideeinrichtung aus dem Band ausgeschnitten werden, und daß dann ein Bestückkopf mit einer Saugpipette die ausgeschnittenen Mikropacks unmittelbar in der Schneidplatte der Ausschneideeinrichtung aufnimmt und in einer vorgebbaren Bestückposition auf dem Substrat absetzt.

Eine erfindungsgemäße Vorrichtung zur Bestückung von Substraten mit Mikropacks ist gekennzeichnet durch

- eine Vorratsrolle, von welcher die Mikropacks in Bandform abziehbar sind,
- eine der Vorratsrolle nachgeordnete Ausschneideeinrichtung zum Ausschneiden der Mikropacks aus dem Band mit einem von unten in die zugeordnete Schneidplatte einführbaren Schneidstempel und durch
- einen Bestückkopf, dessen Saugpipette zur Aufnahme der ausgeschnittenen Mikropacks von oben her in die Schneidplatte der Ausschneideeinrichtung einführbar ist.

Der Erfindung liegt die Erkenntnis zugrunde, das eine automatische Bestückung von Substraten mit Mikropacks mit einer Verarbeitung direkt vom Band dann vorgenommen werden kann, wenn die Schneidplatte einer Ausschneideeinrichtung zum Ausschneiden der Mikropacks aus dem Band als genau definierte Entnahmeposition für die Mikropacks herangezogen wird. Der Bestückkopf nimmt also mit der Saugpipette die ausgeschnittenen Mikropacks unmittelbar in der Schneidplatte stets in der gleichen Lauge auf. Mit einer derart genauen Entnahmeposition in der Schneidplatte ist dann aber auch ohne zusätzliches Zentrieren der Mikropacks ein exaktes Positionieren mit den durch ein Bestückprogramm vorgegebenen Bestückpositionen gewährleistet. Für die Oberflächenmontage der Mikropacks können somit die gleichen Bestückautomaten und die gleichen Löttechnologien wie für die übrigen oberflächen-lötbaren Bauelemente eingesetzt werden.

Gemäß einer bevorzugten Ausgestaltung der Erfindung wird das von der Vorratsrolle abgezogene Band vor der Ausschneideeinrichtung einer Biegeeinrichtung zum Ausformen der Außenanschlüsse der Mikropacks zugeführt. Mit der zwischen Vorratsrolle und Ausschneideeinrichtung angeordneten Biegeeinrichtung kann also das für die Oberflächenmontage der Mikropacks in der Regel erforderliche Ausformen der Außenanschlüsse ohne Unterbrechung des Verarbeitungsflusses vorgenommen werden.

Um eine exakte Lage der Mikropacks in der Ausschneideeinrichtung zu gewährleisten werden vorzugsweise in der Ausschneideeinrichtung vor dem Ausschneiden der Mikropacks Postionierstifte in eine Perforation des Bandes eingeführt. Dies kann mit besonders geringem Aufwand bewerkstelligt werden, wenn die Positionierstifte zusammen mit dem Schneidstempel betätigbar sind.

Gemäß einer weiteren bevorzugten Ausgestaltung der Erfindung ist vorgesehen, daß die ausgeschnittenen Mikropacks im Bereich der Schneidplatte zwischen dem Schneidstempel der Ausschneideeinrichtung und der Saugpipette festgeklemmt werden. Hierdurch wird eine Veränderung der Entnahmeposition durch ein Verschieben der Mikropacks innerhalb der Schneidplatte mit Sicherheit ausgeschlossen. Eine weitere Steigerung der Positioniergenauigkeit wird dann insbesondere dadurch erreicht, daß die ausgeschnittenen Mikropacks mit dem Schneidstempel gegen den Widerstand der Saugpipette aus dem Führungsbereich der Schneidplatte gedrückt werden.

Schließlich ist es für eine gemischte Bestückung von Substraten mit Mikropacks und anderen Bauelementen auch besonders vorteilhaft, wenn der Bestückkopf einen den Mikropacks zugeordneten Saugpipettenadapter selbsttätig aus einer Parkposition abholt. Der in die Schneidplatte der Ausschneideeinrichtung einführbare Saugpipettenadapter kann dann den für das zuverlässige Positionieren gegebenen Anforderungen optimal angepaßt werden.

Ein Ausführungsbeispiel der Erfindung ist in der Zeichnung dargestellt und wird im folgenden näher beschrieben.

Es zeigen:

Fig. 1 ein Band, aus welchem die einzelnen Mikropacks ausgeschnitten werden,

Fig. 2 die Anordnung eines Mikropacks im Band in vergrößerter Darstellung,

Fig. 3 einen Zuführmodul für Mikropacks,

Fig. 4 den Einsatz des in Fig. 3 dargestellten Zuführmoduls in einem Bestückautomaten,

Fig. 5 und 6 Wirkungsweise der in dem Zuführmodul gemäß Fig. 3 eingesetzten Biegevorrichtung zum Ausformen der Außenanschlüsse der Mikropacks,

Fig. 7 bis 10 verschiedene Stadien beim Ausschneiden und bei der Entnahme der Mikropacks in dem in Fig. 3 dargestellten Zuführmodul und die Fig. 11 und 12 verschiedene Schnitte durch die Ausschneideeinrichtung des in Fig. 3 dargestellten Zuführmoduls.

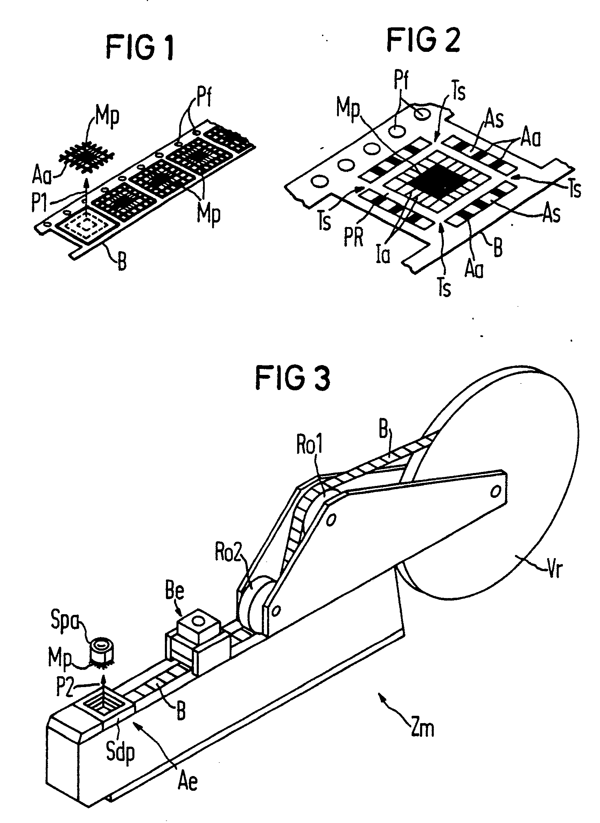

Fig. 1 zeigt ein nach Art eines Filmbandes ausgebildetes Band B, welches seitlich mit einer Perforation Pf versehen und als Träger für einzelne Mikropacks Mp dient. Wie es durch einen Pfeil P1 angedeutet ist, werden die enzelnen Mikropacks Mp so aus dem Band B herausgetrennt, daß die einzelnen Außenanschlüsse Aa frei über einen verbleibenden Polyimid-Rahmen hinausragen.

Fig. 2 zeigt einen vergrößerten Ausschnitt des Bandes B, in welchem die Innenanschlüsse Ia, der Polyimid-Rahmen PR und die Außenanschlüsse Aa zu erkennen sind. In das Band B sind pro Mikropack Mp insgesamt vier rechteckförmige Aussparungen As eingebracht, in welche die Außenanschlüsse Aa ragen und die durch ihre Abstände in den Eckbereichen die Verbindung zwischen Polyimid-Rahmen PR und Band B definieren. Zum Ausschneiden der Mikropacks Mp aus dem Band B werden dann lediglich die verbliebenen Verbindungen zwischen den Aussparungen As in den Eckbereichen durchtrennt, wobei in Fig. 2 die entsprechenden Trennstellen durch Pfeile Ts aufgezeigt sind.

Fig. 3 zeigt in perspektivischer Darstellung einen insgesamt mit Zm bezeichneten Zuführmodul für Mikropacks Mp. In diesem Zuführmodul Zm wird das Band B mit den Mikropacks Mp von einer Vorratsrolle Vr abgezogen und über zwei Rollen Ro1 und Ro2 zunächst einer Biegeeinrichtung Be zum Ausformen der Außenanschlüsse Aa (vergl. Fig. 1 und 2) und dann einer Ausschneideeinrichtung Ae zugeführt, von welcher lediglich die obenliegende Schneidplatte Sdp zu erkennen ist. In Fig. 3 ist ferner angedeutet, daß die Schneidplatte Sdp die Entnahmeposition für die aus dem Band B ausgeschnittenen Mikropacks Mp bildet und daß die Mikropacks Mp in Richtung des Pfeiles P2 mit Hilfe eines Saugpipettenadapters Spa entnommen werden.

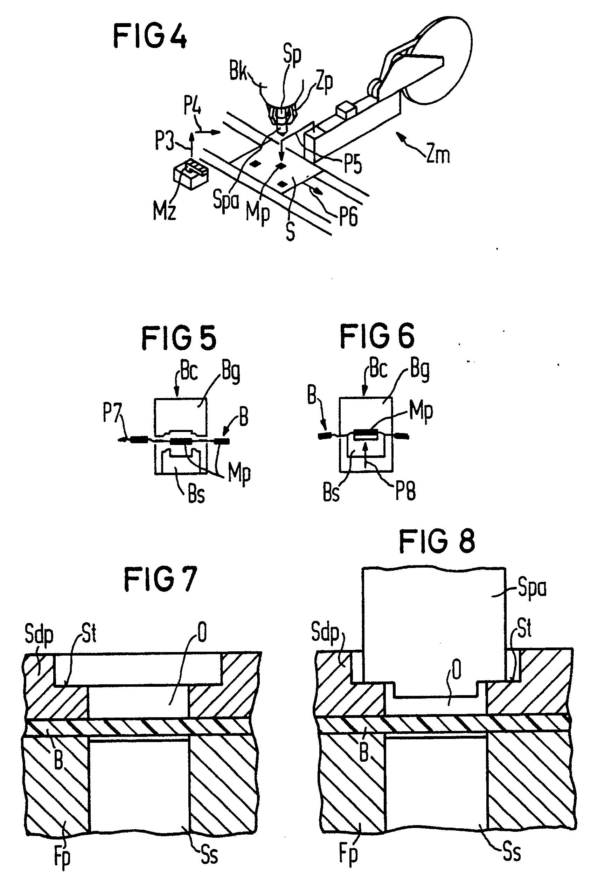

Fig. 4 zeigt in stark vereinfachter schematischer Darstellung den Einsatz des in Fig. 3 dargestellten Zuführmoduls Zm in einem Bestückautomaten für die Bestückung von Substraten S mit oberflächen-lötbaren Bauelementen. Bei diesem Bestückautomaten wird das Substrat S, bei welchem es sich beispielsweise um eine Leiterplatte handelt im Bestückbereich ortsfest zentriert. Seitlich sind der Zuführmodul Zm für die Bereitstellung der Mikropacks Mp und weitere in der Zeichnung nicht dargestellte Zuführmodule für die Bereitstellung anderer oberflächen-lötbarer Bauelemente angeordnet. Über diesen fest aufgebauten Aggregaten bewegt sich ein Bestückkopf Bk der an eine in der Zeichnung nicht dargestellte, freiprogrammierbare Positioniereinheit mit zwei Freiheitsgraden angeflanscht ist. Der Bestückkopf Bk entnimmt mit einer Saugpipette Sp die Bauelemente aus den Spuren der entsprechenden Zuführmodule, zentriert die Bauelemente in zwei Achsrichtungen durch die Betätigung von zwei Zangenpaaren Zp, dreht die aufgenommenen und zentrierten Bauelemente erforderlichenfalls in die Einbaulage und setzt die Bauelemente dann in den vorgegebenen Bestückpositionen auf dem Substrat S ab. Für die Bestückung mit Mikropacks Mp holt der Bestückkopf Bk zunächst einen den Mikropacks Mp angepaßten Saugpipettenadapter Spa selbsttätig aus einem seitlich angeordneten Magazin Mz ab, wie es durch Pfeile P3 und P4 angedeutet ist. Mit dem Saugpipettenadapter Spa werden die Mikropacks Mp dann aus dem Zuführmodul Zm entnommen und in den vorgegebenen Bestückpositonen auf dem Substrat S abgesetzt, so wie es durch den Pfeil P5 angedeutet ist. Nach der vollständigen Bestückung mit Mikropacks Mp und den anderen oberflächen-lötbaren Bauelementen werden die Substrate S dann in Richtung des Pfeiles P6 zum Abschluß der Oberflächenmontage durch ein Reflow-Lötverfahren und insbesondere durch Dampfphasenlötung weitertransportiert.

Die Fig. 5 und 6 zeigen in stark vereinfachter schematischer Darstellung die Wirkungsweise der Biegeeinrichtung Be des in den Fig. 3 und 4 dargestellten Zuführmoduls Zm. Die Biegeeinrichtung Be besteht aus einem ortsfest angeordneten Biegegesenk Bg und einem heb- und senkbaren Biegestempel Bs. Gemäß Fig. 5 wird das Band B mit den einzelnen Mikropacks Mp in Richtung des Pfeiles P7 schrittweise derart vorwärts transportiert, daß jeweils das nächste Mikropack Mp, dessen Außenanschlüsse Aa (vergl. Fig. 1 und 2) ausgeformt werden sollen, genau in der richtigen Lage zwischen dem oberen Biegegesenk Bg und dem abgesenkten Biegestempel Bs angeordnet ist. Zum Ausformen der Außenanschlüsse Aa (vergl. Fig. 1 und 2) wird dann der Biegestempel Bs in Richtung des Pfeiles P8 nach oben gefahren, wobei die nicht zu verformenden Teile des Mikropacks Mp in entsprechenden Ausnehmungen des Biegestempels Bs und des Biegegesenks Bg aufgenommen werden.

Die Fig. 7 bis 10 zeigen verschiedene Stadien beim Ausschneiden der Mikropacks Mp aus dem Band B und bei der Entnahme der ausgeschnittenen Mikropacks Mp aus der Ausschneideeinrichtung des in Fig. 3 dargestellten Zuführmoduls Zm. In Fig. 7 sind von dieser Ausschneideeinrichtung die bereits in Fig. 3 dargestellte Schneidplatte Sdp und der in einer Führungsplatte Fp geführte Schneidstempel Ss zu erkennen. Zwischen der Schneidplatte Sdp und der Führungsplatte Fp befindet sich das Band B, welches schrittweise in einer zur Zeichnungsebene senkrechten Richtung bewegt wird. Die Schneidplatte Sdp besitzt eine Öffnung O, die so bemessen ist, daß der Schneidstempel Ss eindringen kann und die sich nach oben hin mit einer Stufe St etwas erweitert.

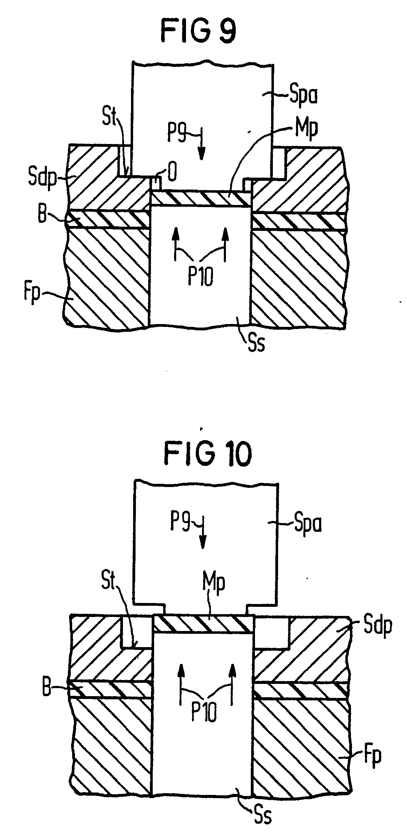

Gemäß Fig. 8 wird der an die Saugpipette Sp des Bestückkopfes Bk angefügte Saugpipettenadapter Spa (vergl. Fig. 4) zunächst in die Öffnung O der Schneidplatte Sdp so eingeführt, daß er mit einer nicht näher bezeichneten Stufe auf der Stufe St aufliegt. Anschließend wird gemäß Fig. 9 der Schneidstempel Ss nach oben bewegt, wobei ein hier rein schematisch dargestelltes Mikropack Mp aus dem Band B ausgeschnitten und zwischen Schneidstempel Ss und Saugpipettenadapter Spa festgeklemmt wird. Der durch einen Pfeil P9 aufgezeigte Druck mit dem der Saugpipettenadapter Spa nach unten gedrückt wird ist dabei geringer als der durch zwei Pfeile P10 aufgezeigte Druck, mit dem der Schneidstempel Ss nach oben gedrückt wird. Demzufolge wird dann gemäß Fig. 10 der Saugpipettenadapter Spa von der Stufe St abgehoben und das ausgeschnittene Mikropack Mp nach oben über die Stufe St hinaus aus der Öffnung O gedrückt. Der Saugpipettenadapter Spa hebt dann das Mikropack Mp nach oben ab und setzt es in der in Fig. 4 bereits aufgezeigten Weise auf dem zu bestückenden Substrat S ab.

Anhand der Fig. 7 bis 10 ist ohne weiteres zu erkennen, daß ein aus dem Band B ausgeschnittenes Mikropack Mp zunächst noch in der Öffnung O der Schneidplatte Sdp geführt ist. Durch diese Führung der ausgeschnittenen Mikropacks Mp in der Schneidplatte Sdp ergibt sich eine genau definierte Ausgangsposition, die ein zuverlässiges Positionieren der Mikropacks Mp auf dem zu bestückenden Substrat S (vergl. Fig. 4) ermöglicht.

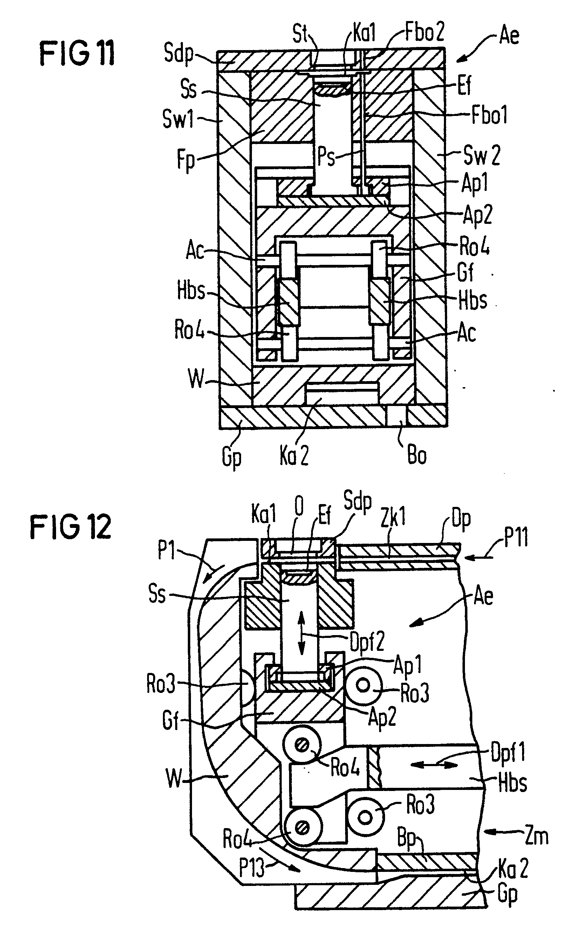

Die Flg. 11 und 12 zeigen verschiedene Längsschnitte durch die mit Ae bezeichnete Ausschneideeinrichtung des in Fig. 3 dargestellten Zuführmoduls Zm. Zwischen der oben angeordneten Schneidplatte Sdp und einer unteren Grundplatte Gp befinden sich zwei gerade Seitenwandungen Sw1 und Sw2, während die vordere stirnseitige Wand W eine gewölbte Form aufweist. An die Schneidplatte Sdp schließt sich nach hinten die mit Dp bezeichnete Deckplatte des Zuführmoduls Zm an, wobei sich in der Deckplatte Dp ein Zuführkanal Zk1 für die Zufuhr des Bandes B (vergl. Fig. 1 bis 10) in Richtung des Pfeiles P11 befindet. Die beiden Seitenwandungen Sw1 und Sw2 und die Grundplatte Gp erstrecken sich nach hinten über den gesamten Zuführmodul Zm.

An den vorstehend erwähnten Zuführkanal Zkl schließt sich ein Kanal Ka1, an welcher sich zwischen der Schneidplatte Sdp und der Führungsplatte Fp des Schneidstempels Ss befindet und durch eine Flache, der Form des Bandes B angepaßte Ausfräßung der Führungsplatte Fp gebildet ist. Nach dem Ausschneiden der Mikropacks Mp wird das Band B aus dem Kanal Ka1 geführt, über die Wölbung der stirnseitigen Wand W entsprechend den Pfeilen P12 und P13 umgelenkt und durch einen Kanal Ka2 abgeführt, wobei sich dieser Kanal Ka2 zwischen der Grundplatte Gp und einer dünneren Bodenplatte Bp des Zuführmoduls Zm befindet.

In Fig. 11 ist in der Grundplatte Gp eine Bohrung Bo zu erkennen, in welche bei der Anordnung des Zuführmoduls Zm auf einem Bestückautomaten ein Paßstift eingreift. Im übrigen wird der Zuführmodul Zm auf dem Tisch bes Bestückautomaten durch sein Eigengewicht und durch Magnetkraft gehalten.

Der Schneidstempel Ss ist an seiner Oberseite mit einer Einfräsung Ef Versehen, die so bemessen ist, daß sie den dickeren Ic-Bereich eines Mikropacks Mp aufnehmen und beim Ausschneidevorgang vor Beschädigungen bewahren kann. Im übrigen muß der Schneidstempel Ss ja nur die in Fig. 2 dargestellten Trennstellen Ts durchtrennen. Die Befestigung des Schneidstempels Ss erfolgt in einer Stempelaufnahme, die aus einer oberen Aufnahmeplatte Ap1 und einer unteren Aufnahmeplatte Ap2 zusammengesetzt und in einer Geradführung Gf formschlüssig gehalten ist. Die vertikale Führung dieser Geradführung Gf erfolgt durch mehrere in Fig. 12 erkennbare Rollen Ro3, während für den hin- und hergehenden Antrieb in vertikaler Richtung weitere mittels Achsen Ac in der Geradführung Gf gelagerte Rollen Ro4 und eine in horizontaler Richtung gemäß dem Doppelpfeil Dpf1 hin- und herbewegbare Hubstange Hbs vorgesehen sind. Die Hubstange Hbs ist in ihrem vorderen Bereich gegabelt und derart abgekröpft, daß ihre horizontale Hin- und Herbewegung Dpf1 in eine vertikale Auf- und Abbewegung des Schneidstempels Ss entsprechend dem Doppelpfeil Dpf2 umgesetzt wird.

Die über einen in der Zeichnung nicht dargestellten Kurbeltrieb angetriebene Hubstange Hbs dient auch zum Antrieb der Biegeeinrichtung Be (vergl. Fig. 3, 5 und 6), deren Biegestempel Bs über eine weitere Kröpfung auf- und abbewegt wird. Von der Hubstange Hbs wird ferner ein zwischen Biegeeinrichtung Be und Ausschneideeinrichtung Ae angeordnetes Antriebsaggregat betätigt, welche das Band B durch Eingriff in dessen Perforation Pf (vergl. Fig. 1 bis 3) in Richtung des Pfeiles P11 schrittweise derart vorwärtsbewegt, daß jeweils ein Mikropack Mp genau über dem Biegestempel Bs (vergl. Fig. 5 und 6) bzw. über dem Schneidstempel Ss angeordnet ist. Das in der Zeichnung nicht dargestellte Antriebsaggregat kann dabei so aufgebaut werden, wie die in Filmkameras für den schrittweisen Transport der Filme eingesetzten Antriebsaggregate.

Wird das Band B in Richtung des Pfeiles P11 vorwärtstransportiert bis das nächste Mikropack Mp in der Ausschneideeinrichtung Ae angeordnet ist, so wird vor dem eigentlichen Ausschneidevorgang noch eine Feinpositionierung vorgenommen, die ein äußerst genaue und reproduzierbare Relativlage zwischen Mikropack Mp und Ausschneideeinrichtung Ae gewährleistet. Diese Feinpositionierung erfolgt mit Hilfe von zwei im Abstand zueinander angeordneten Positionierstiften Ps, die in der aus den Aufnahmeplatten Ap1 und Ap2 bestehenden Stempelaufnahme befestigt sind und in Führungsbohrungen Fbo1 der Führungsplatte Fp geführt sind. Die Positionierstifte Ps werden also zusammen mit dem Schneidstempel Ss betätigt. Die Länge der Positionierstifte Ps ist dabei derart bemessen, daß sie kurz vor dem Ausschneiden eines Mikropacks Mp in die Perforation Pf des Bandes B eingeführt werden und dadurch eine Feinpositionierung mit einer exakten Relativlage von Mikropack Mp und Schneidstempel Ss bzw. Schneidplatte Sdp bewirken. Beim Ausschneiden eines Mikropacks Mp dringen die Positionierstifte Ps dann in entsprechende Führungsbohrungen Fbo2 der Schneidplatte Sdp ein.

Aufgrund vorstehend beschriebenen Feinpositionierung nehmen die ausgeschnittenen Mikropacks Mp stets dieselbe Lage innerhalb der Öffnung O der Schneidplatte Sdp ein. Gemäß der schematischen Darstellung in den Fig. 7 bis 10 wird dann die Öffnung O der Schneidplatte Sdp als Entnahmeposition für Mikropacks Mp herangezogen, d. h. es liegt eine definierte Ausgangsposition vor und die Mikropacks Mp können dann mit dem Bestückkopf Bk exakt in den programmierten Bestückpositionen des Substrats S (vergl. Fig. 4) abgesetzt werden. Eine mechanische Beschädigung oder sonstige Beeinträchtigung der Mikropacks Mp ist dabei nicht zu befürchten.

## Ansprüche

1. Verfahren zur Bestückung von Substraten mit Mikropacks nach dem Pick & Place Prinzip, dadurch **gekennzeichnet**, daß die Mikropacks (Mp) in Bandform von einer Vorratsrolle (Vr) abgezogen und in einer Ausschneideeinrichtung (Ae) aus dem Band (B) ausgeschnitten werden und daß dann ein Bestückkopf (Bk) mit einer Saugpipette (Sp) die ausgeschnittenen Mikropacks (Mp) unmittelbar in der Schneidplatte (Sdp) der Ausschneideeinrichtung (Ae) aufnimmt und in einer vorgebbaren Bestückposition auf dem Substrat (S) absetzt.

2. Verfahren nach Anspruch 1, dadurch **gekennzeichnet**, daß das von der Vorratsrolle (Vr) abgezogene Band (B) vor der Ausschneideeinrichtung (Ae) einer Biegeeinrichtung (Be) zum Ausformen der Außenanschlüsse (Aa) der Mikropacks (Mp) zugeführt wird.

3. Verfahren nach Anspruch 1 oder 2, dadurch **gekennzeichnet**, daß in der Ausschneideeinrichtung (Ae) vor dem Ausschneiden der Mikropacks (Mp) Positionierstifte (Ps) in eine Perforation (Pf) des Bandes (B) eingeführt werden.

4. Verfahren nach einem der vorhergehenden Ansprüche, dadurch **gekennzeichnet**, daß die ausgeschnittenen Mikropacks (Mp) im Bereich der Schneidplatte (Sdp) zwischen dem Schneidstempel (Ss) der Ausschneideeinrichtung (Ae) und der Saugpipette (Sp) festgeklemmt werden.

5. Verfahren nach Anspruch 4, dadurch **gekennzeichnet**, daß die ausgeschnittenen Mikropacks (Mp) mit dem Schneidstempel (Ss) gegen den Widerstand der Saugpipette (Sp) aus dem Führungsbereich der Schneidplatte (Sdp) gedrückt werden.

6. Verfahren nach einem der vorhergehenden Ansprüche, dadurch **gekennzeichnet,** daß der Bestückkopf (Bk) einen den Mikropacks (Mp) zugeordneten Saugpipettenadapter (Spa) selbsttätig aus einer Parkposition abholt.

7. Vorrichtung zur Bestückung von Substraten mit Mikropacks, **gekennzeichnet,** durch
    - eine Vorratsrolle (Vr), von welcher die Mikropacks (Mp) in Bandform abziehbar sind,
    - eine der Vorratsrolle (Vr) nachgeordnete Ausschneideeinrichtung (Ae) zum Ausschneiden der Mikropacks (Mp) aus dem Band (B) mit einem von unten in die zugeordnete Schneidplatte (Sdp) einführbaren Schneidstempel (Ss) und durch
    - einen Bestückkopf (Bk) dessen Saugpipette (Sp) zur Aufnahme der ausgeschnittenen Mikropacks (Mp) von oben her in die Schneidplatte (Sdp) der Ausschneideeinrichtung (Ae) einführbar ist.

8. Vorrichtung nach Anspruch 7, dadurch **gekennzeichnet,** daß zwischen der Vorratsrolle (Vr) und der Ausschneideeinrichtung (Ae) eine Biegeeinrichtung (Be) zum Ausformen der Außenanschlüsse (Aa) der Mikropacks (Mp) angeordnet ist.

9. Vorrichtung nach Anspruch 7 oder 8, dadurch **gekennzeichnet,** daß in der Ausschneideeinrichtung (Ae) zwei in eine Perforation (Pf) des Bandes (B) einführbare Positionierstifte (Ps) angeordnet sind.

10. Vorrichtung nach Anspruch 9, dadurch **gekennzeichnet,** daß die Positionierstifte (Ps) zusammen mit dem Schneidstempel (Ss) betätigbar sind.

11. Vorrichtung nach einem der Ansprüche 7 bis 10, dadurch **gekennzeichnet,** daß die Vorratsrolle (Vr) und die Ausschneideeinrichtung (Ae) in einem auswechselbaren Zuführmodel (Zm) angeordnet sind.

12. Vorrichtung nach den Ansprüchen 8 und 11, dadurch **gekennzeichnet,** daß die Biegeeinrichtung (Be) ebenfalls im Zuführmodul (Zm) angeordnet ist.

13. Vorrichtung nach einem der Ansprüche 7 bis 12, dadurch **gekennzeichnet,** daß in einem Magazin (Mz) mindestens ein vom Bestückkopf (Bk) aufnehmbarer Saugpipettenadapter (Spa) bereitgestellt ist.

**Claims**

1. Process for mounting substrates with micropackages according to the pick and place principle, characterised in that the micropackages (Mp) are taken off in strip form from a storage roller (Vr) and cut out from the strip (B) in an excising device (Ae), and in that a mounting head (Bk) having a suction pipette (Sp) then picks up the cutout micropackages (Mp) directly in the cutting plate (Sdp) of the excising device (Ae) and places them in a prescribed mounting position on the substrate(S).

2. Process according to Claim 1, characterised in that the strip (B) taken off from the storage roller (Vr) is fed in front of the excising device (Ae) to a bending device (Be) for the purpose of forming the external terminals (Aa) of the micropackages (Mp).

3. Process according to Claim 1 or 2, characterised in that before the excision of the micropackages (Mp) positioning pins (Ps) are inserted in the excising device (Ae) to a perforation (Pf) of the strip (B).

4. Process according to one of the preceding claims, characterised in that the cutout micropackages (Mp) are clamped in the region of the cutting plate (Sdp) between the cutting punch (Ss) of the excising device (Ae) and the suction pipette (Sp).

5. Process according to Claim 4, characterised in that the cutout micropackages (Mp) are pressed out of the guide region of the cutting plate (Sdp) with the cutting punch (Ss) against the resistance of the suction pipette (Sp).

6. Process according to one of the preceding claims, characterised in that the mounting head (Bk) automatically receives a suction pipette adaptor (Spa) assigned to the micropackages (Mp) from a parking position.

7. Apparatus for mounting substrates with micropackages according to the Pick and Place principle, characterised by
    - a storage roller (Vr), from which the micropackages (Mp) can be taken off in strip form,
    - an excising device (Ae) downstream of the storage roller (Vr) for cutting out the micropackages (Mp) from the strip (B) having a cutting punch (Ss) which can be introduced from below into the assigned cutting plate (Sdp), and by
- a mounting head (Bk), whose suction pipette (Sp) can be introduced from above for the purpose of picking up the cutout micropackages (Mp) into the cutting plate (Sdp) of the excising device (Ae).

8. Apparatus according to Claim 7, characterised in that a bending device (Be) is arranged between the storage roller (Vr) and the excising device (Ae) for the purpose of forming the external terminals (Aa) of the micropackages (Mp).

9. Apparatus according to Claim 7 or 8, characterised in that two positioning pins (Ps) which can be introduced into a perforation (Pf) of the strip (B) are arranged in the excising device (Ae).

10. Apparatus according to Claim 9, characterised in that the positioning pins (Ps) can be actuated together with the cutting punch (Ss).

11. Apparatus according to one of Claims 7 to 10, characterised in that the storage roller (Vr) and the excising device (Ae) are arranged in an exchangeable feed module (Zm).

12. Apparatus according to Claims 8 and 11, characterised in that the bending device (Be) is likewise arranged in the feed module (Zm).

13. Apparatus according to one of Claims 7 to 12, characterised in that at least one suction pipette adaptor (Spa) that can be picked up by the mounting head (Bk) is provided in a magazine (Mz).

## Revendications

1. Procédé pour installer des microboîtiers sur des substrats selon le procédé Pick & Place, caractérisé par le fait qu'on retire les microboîtiers (Mp) sous la forme d'une bande à partir d'un rouleau de réserve (Vr) et qu'on les découpe à partir de la bande (B) dans un dispositif de découpage (Ae), et qu'ensuite une tête de montage (Pk) équipée d'une pipette d'aspiration (Sp) saisit les microboîtiers (Mp) découpés, directement dans la plaque de découpage (Sdp) du dispositif de découpage (Au) et les dépose sur le substrat (S) dans une position de montage pouvant être prédéterminée.

2. Procédé suivant la revendication 1, caractérisé par le fait que la bande (B) tirée du rouleau de réserve (Vr) est amenée, en amont du dispositif de découpage (Ae), à un dispositif de pliage (Be) servant à former les bornes extérieures (Aa) des microboîtiers (Mp).

3. Procédé suivant la revendication 1 ou 2, caractérisé par le fait que des broches de positionnement (Ps) sont insérées dans une perforation (Pf) de la bande (B), dans le dispositif de découpage (Ae), avant le découpage des microboîtiers (Mp).

4. Procédé suivant l'une des revendications précédentes, caractérisé par le fait que les microboîtiers découpés (Mp) sont bloqués dans la zone de la plaque de découpage (Sdp) entre le poinçon de découpage (Ss) du dispositif de découpage (Ae) et la pipette d'aspiration (Sp).

5. Procédé suivant la revendication 4, caractérisé par le fait que les microboîtiers découpés (Mp) sont repoussés au moyen du poinçon de découpage (Ss), à l'encontre de la résistance de la pipette d'aspiration (Sp), hors de la zone de guidage de la plaque de découpage (Sdp).

6. Procédé suivant l'une des revendications précédentes, caractérisé par le fait que la tête de montage (Bk) va chercher automatiquement, d'une position rangée, un adaptateur (Spa) pour la pipette d'aspiration, associé aux microboîtiers (Mp).

7. Dispositif pour installer des microboîtiers sur des substrats selon le procédé Pick & Place, caractérisé par
- un rouleau de réserve (Vr), d'où les microboîtiers (Mp) peuvent être tirés sous la forme d'une bande,
- un dispositif de découpage (Ae) installé en aval du rouleau de réserve (Vr) et servant à découper les microboîtiers (Mp) à partir de la bande (B), avec un poinçon de découpage (Ss) pouvant être introduit par-dessous dans la plaque de découpage (Sdp) associée, et
- une tête de montage (Bk), dont la pipette d'aspiration (Sp) peut être introduite à partir du haut dans la plaque de découpage (Sdp) du dispositif de découpage (Ae), pour saisir le microboîtier (Mp) découpé.

8. Dispositif suivant la revendication 7, caractérisé par le fait qu'un dispositif de pliage (Be) servant à mettre en forme les bornes extérieures (Aa) des microboîtiers (Mp) est disposé entre le rouleau de réserve (Vr) et le dispositif de découpage (Ae).

9. Dispositif suivant la revendication 7 ou 8, caractérisé par le fait que deux broches de positionnement (Ps), pouvant être introduites dans une perforation (Pf) de la bande (B), sont disposées dans le dispositif de découpage (Ae).

10. Dispositif suivant la revendication 9, caractérisé par le fait que les broches de positionnement (Pa) peuvent être actionnées conjointement avec le poinçon de découpage (Ss).

11. Dispositif suivant l'une des revendications 7 à 10, caractérisé par le fait que le rouleau de réserve (Vr) et le dispositif de découpage (Ae) sont disposés dans un module interchangeable d'amenée (Zm).

12. Dispositif suivant les revendications 10 et 11, caractérisé par le fait que le dispositif de pliage (Be) est également disposé dans le module d'amenée (Zm).

13. Dispositif suivant l'une des revendications 7 à 12, caractérisé par le fait qu'au moins un adaptateur (Spa) de la pipette s'aspiration, qui peut être saisi par la tête de montage (Bk), est préparé dans un magasin (Mz).

# FIG 1

# FIG 2

# FIG 3

EP 0 224 747 B1

# FIG 4

# FIG 5

# FIG 6

# FIG 7

# FIG 8

11

EP 0 224 747 B1

# FIG 9

# FIG 10

12

EP 0 224 747 B1

**FIG 11**

**FIG 12**